# EUROPEAN PATENT APPLICATION

(11) **EP 3 502 301 A1**
(43) Date of publication of application: **26.06.2019**
(21) Application number: 17209215.7
(22) Date of filing: 21.12.2017
(51) Int. Cl.: C23C 2/08, C23C 14/14, C23C 30/00, C25D 7/00

(54) **COATING FOR A COMPONENT, COMPONENT WITH A COATING AND METHOD OF APPLYING A COATING TO A COMPONENT**

(71) Applicant: TE Connectivity Germany GmbH, 64625 Bensheim (DE)
(72) Inventor: Crandall, Erika, 69517 Gorxheimertal (DE)
(74) Representative: Grünecker Patent- und Rechtsanwälte PartG mbB

(57) **Abstract**

The invention discloses a coating (1) for a component (2), in particular an electrical component, wherein the coating comprises tin (10), characterized in that the coating comprises aluminium (11) and/or magnesium (12). Further, the invention discloses a component (2) with such a coating (1). Moreover, a method for applying the coating (1) is disclosed.

## Description

The invention relates to a coating for a component, in particular an electrical component, wherein the coating comprises tin. Further, the invention relates to a component with a coating. Moreover, the invention relates to a method of applying a coating to a component.

Components such as electrical components are often covered with a layer that comprises tin (Sn) for various reasons. However, tin tends to form long, needle-shaped elements protruding from the surface due, for example, to internal pressure in the coating or externally applied pressure, for example if the coating is in contact with a counter-element. Previously, lead (Pb) was added to avoid the growth of these so-called whiskers. However, due to recent regulations, the use of lead has to be reduced or avoided completely.

The object of the invention is thus to provide a solution that reduces or avoids the use of lead while providing a coating with a reduced whisker growth or with no whisker growth at all.

According to the invention, this is achieved if the coating comprises aluminium and/or magnesium.

A component according to the invention, in particular an electrical component such as a contact element, is coated with a coating according to the invention.

In a method of applying a coating to a component, aluminium and/or magnesium are used in the coating. Thus, the application also covers the use of magnesium and/or aluminium in a coating comprising tin for avoiding or reducing whisker growth.

It has been found that these two elements help to reduce or avoid the growth of whiskers in coatings comprising tin.

The inventive solution can be improved by the following further improvements and advantageous embodiments, which are advantageous on their own and can be combined arbitrarily as desired.

In an advantageous development, the coating is lead-free. Such a lead-free coating is environmentally friendly.

In a solution that is easy to implement while maintaining the advantageous reduction or avoidance of whisker growth, no further components except for unavoidable impurities are present in the coating. If only one of aluminium or magnesium is used, the coating can comprise only two components, namely tin and aluminium or magnesium.

In order to lower the use of possibly expensive materials, the coating can comprise less than 10 at. % aluminium and/or magnesium. The term at. % refers to atomic percent, meaning that a certain number of atoms out of 100 atoms of the coating is of the respective element.

Preferably, magnesium and/or aluminium make up less than 5 at. %, especially less than 3 at. % of the coating in order to keep production costs low.

In an advantageous embodiment, the thickness of the coating layer is between 10 and 1000 nm. Such a thickness can offer a good compromise between the desired functionality and the amount of material that is used for the coating. Preferably, the thickness of the coating layer is between 100 and 500 nm.

Preferably, the coating is applied by physical vapour deposition, in particular by sputter deposition. With this method, the mixing of tin and magnesium and/or aluminium can be achieved easily, for example by simultaneously evaporating the elements.

In an alternative embodiment, the coating can be applied by hot dip plating. Such an approach may be easier to implement. For example, tin and magnesium and/or aluminium can be melted together and the component can then be dipped into the liquid phase.

In a further embodiment, the coating can be applied by electrodeposition. Such an embodiment can, for example, be applied if hot dip plating is not possible due to the use of heat-sensitive materials or if physical vapour deposition is too slow. However, due to the nature of magnesium and aluminium, electroplating might not be a reliable option, especially when codepositing it with tin, unless special measures are taken to enable this.

In the following, the inventive solutions will be explained in more detail and with reference to the drawings. The features shown in the further developments and advantageous embodiments can be combined as desired and are advantageous on their own.

In the figures:
Fig. 1 shows a schematic cross-section through a component with a coating layer; and
Fig. 2 shows a schematic top view of a component with a coating layer.

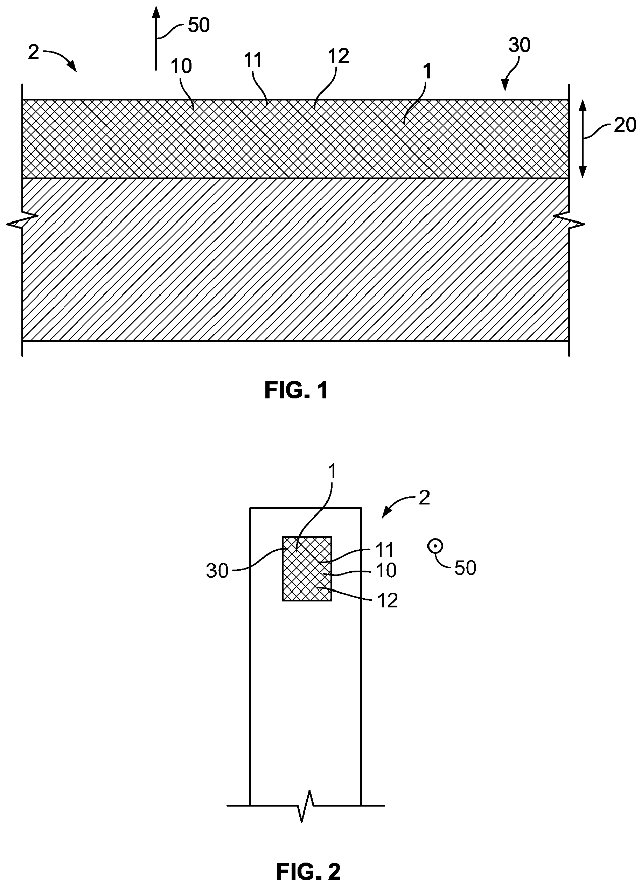

In Fig. 1, a cross-section through the component 2 with a coating layer 30 made of a coating 1 is shown. The component 2 can, for example, be an electrical component such as a contact element. The component 2 can also be another type of component with a coating layer 30.

The coating layer 30 can serve to protect the component 2 from contact with aggressive substances, for example with moisture or oxygen from the atmosphere. The coating layer 30 can thus serve as a corrosion protection layer.

The coating 1 comprises tin 10. Due to internal pressures or due to the forces that are applied, for example, if the component is used together with other components, hair-like or needle-like structures would grow in an outwards direction 50 out of the layer coating layer 30 if pure tin is used. These so-called whiskers can lead to undesired contact with other components. To avoid this, previous solutions have added lead to the coating 1. This leads to a significant reduction or total absence of whisker growth. However, the use of lead has recently been restricted. Therefore, a need for a solution that reduces or avoids whisker growth exists.

The coating 1 also comprises aluminium 11 and/or magnesium 12. This helps to avoid or at least reduce the growth of whiskers. The amount of aluminium 11 and/or magnesium 12 that is necessary for achieving this effect may be very low. For example, the coating 1 may contain less then 10 at. % of these elements. Even lower concentrations can be sufficient for achieving the effect, for example less than 5 at. % and especially less than 3 at. %. Using low concentrations can help to reduce costs, as these additives can be expensive. However, concentrations higher than 10 at. % can also be present.

Preferably, no further components are present in the coating 1, apart from unavoidable impurities. This helps to keep the production process simple.

In particular, no lead can be present so that the coating 1 is lead-free.

A thickness 20 of the coating layer 30 is preferably between 10 and 1000 nm. The thinner the coating layer 30, the less material has to be used and the simpler the production process is. However, a certain thickness is needed in order for the coating layer 30 to fulfill the desired function. Preferably, the thickness 20 is between 100 and 500 nm.

The coating layer 30 can be produced by different methods. It can, for example, be produced by physical vapour deposition and, in particular, by sputtering. In this method, the material of the future coating layer 30 is evaporated and the as yet uncovered component 2 is located in the vicinity of the vapour source. The vapour than covers the component 2 and produces the coating layer 30. To achieve a mixture of two or three components, two or three sources can be used and operated simultaneously.

In an alternative approach, the coating layer 30 can be produced by hot dip plating. In this method, the as yet uncovered component 2 is dipped into a liquid of the coating material.

In a further approach, the coating 30 is produced by electroplating the materials onto the uncovered component 2. However, due to the nature of magnesium 12 and aluminium 11, electroplating might not be a reliable option, especially when codepositing it with tin 10, unless special measures are taken to enable this.

In Fig. 2, a top view of a component 2 is shown. It can be seen that the coating 1 can be applied only on a part of the component 2. For example, only a contact area 60 in which the component 2 comes in contact with a counter-element, for example a counter-connection element, can be covered.

### REFERENCE NUMERALS

- 1: coating
- 2: component
- 10: tin
- 11: aluminium
- 12: magnesium
- 20: thickness
- 30: coating layer
- 50: outwards direction
- 60: contact area

## Claims

1. Coating (1) for a component (2), in particular an electrical component, wherein the coating comprises tin (10), **characterized in that** the coating comprises aluminium (11) and/or magnesium (12).

2. Coating (1) according to claim 1, wherein the coating (1) is lead-free.

3. Coating (1) according to one of claims 1 or 2, wherein except for unavoidable impurities no further components are present in the coating (1).

4. Coating (1) according to one of claims 1 to 3, wherein the coating (1) comprises less than 10 at. % aluminium (11) and/or magnesium (12).

5. Component (2), in particular an electrical component, such as a contact element, coated with a coating layer (30) of the coating (1) according to one of claims 1 to 4.

6. Component (2) according to claim 5, wherein a thickness (20) of the coating layer (30) is between 10 and 1000 nm.

7. Method of applying a coating (1) to a component (2), wherein tin is used in the coating (1), **characterized in that** aluminium (11) and/or magnesium (12) are used in the coating (1).

8. Method according to claim 7, wherein the coating (1) is applied by physical vapour deposition, in particular by sputter deposition.

9. Method according to one of claims 7 or 8, wherein the coating (1) is applied by hot dip plating.

10. Method according to one of claims 7 to 9, wherein the coating (1) is applied by electrodeposition.

11. Use of aluminium (11) and/or magnesium (12) in a coating (1) comprising tin (10) for avoiding or reducing whisker growth.
